# EUROPÄISCHE PATENTANMELDUNG

(11) **EP 3 121 858 A1**
(43) Veröffentlichungstag der Anmeldung: **25.01.2017**
(21) Anmeldenummer: 16187689.1
(22) Anmeldetag: 07.07.2008
(51) Int. Cl.: H01L 33/00, H01L 33/14, H01L 33/04, H01L 33/38, H01L 33/40, H01L 33/42

(54) **HALBLEITERCHIP UND VERFAHREN ZUR HERSTELLUNG EINES HALBLEITERCHIPS**

(30) Priorität: 12.07.2007 DE 102007032555
(62) Teilanmeldung aus: 08159845.0
(71) Anmelder: Osram Opto Semiconductors Gmbh, 93055 Regensburg (DE)
(72) Erfinder: Fehrer, Michael, 93077 Bad Abbach (DE); Strauß, Uwe, 93077 Bad Abbach (DE)
(74) Vertreter: Epping - Hermann - Fischer

(57) **Zusammenfassung**

Es wird ein Halbleiterchip (1) angegeben, der einen Halbleiterkörper (2) mit einer Halbleiterschichtenfolge umfasst, die einen zur Erzeugung von Strahlung vorgesehenen Bereich (23) aufweist. Auf dem Halbleiterkörper (2) ist ein Kontakt (4) angeordnet. Zwischen dem Kontakt (4) und dem aktiven Bereich (23) ist eine Injektionsbarriere (5) ausgebildet.

Weiterhin wird ein Verfahren zur Herstellung eines Halbleiterchips angegeben.

## Beschreibung

Die Erfindung betrifft einen Halbleiterchip sowie ein Verfahren zur Herstellung eines Halbleiterchips.

Bei einem LED-Halbleiterchip wird die Auskoppeleffizienz, also das Verhältnis von aus dem Halbleiter austretender Strahlungsleistung zur im Halbleiterchip erzeugten Strahlungsleistung, von zahlreichen Verlustprozessen beeinflusst. Insbesondere Absorptionsverluste können die Ursache für eine Verringerung der Auskoppeleffizienz sein.

Es ist eine Aufgabe der vorliegenden Erfindung einen Halbleiterchip anzugeben, der eine verbesserte Auskoppeleffizienz aufweist. Weiterhin soll ein Verfahren zur vereinfachten Herstellung eines Halbleiterchips mit hoher Auskoppeleffizienz angegeben werden.

Diese Aufgaben werden durch einen Halbleiterchip gemäß Patentanspruch 1 beziehungsweise durch ein Verfahren gemäß Patentanspruch 13 gelöst sowie durch einen Halbleiterchip beziehungsweise ein Verfahren gemäß den nachstehenden Aspekten 1 und 13 gelöst. Vorteilhafte Ausgestaltungen und Weiterbildungen der Erfindung sind Gegenstand der abhängigen Patentansprüche.

Gemäß einer Ausführungsform umfasst ein erfindungsgemäßer Halbleiterchip einen Halbleiterkörper mit einer Halbleiterschichtenfolge, die einen zur Erzeugung von Strahlung vorgesehenen aktiven Bereich aufweist. Auf dem Halbleiterkörper ist ein Kontakt angeordnet.

Zwischen dem Kontakt und dem aktiven Bereich ist eine Injektionsbarriere ausgebildet.

Im Betrieb des Halbleiterchips ist die vertikale Injektion von Ladungsträgern vom Kontakt in den aktiven Bereich mittels der Injektionsbarriere vermindert. In einer Aufsicht auf den Halbleiterchip erfolgt die Injektion von Ladungsträgern in den aktiven Bereich überwiegend neben dem Kontakt. Der Kontakt weist hierfür zweckmäßigerweise eine geringere laterale Ausdehnung auf als der aktive Bereich. Unterhalb des Kontakts ist die Injektion von Ladungsträgern in den aktiven Bereich dagegen vermindert. Auf diese Weise kann die Wahrscheinlichkeit, dass Strahlung unterhalb des Kontakts im aktiven Bereich erzeugt und nachfolgend vom Kontakt absorbiert wird, vermindert werden. Mit anderen Worten wird Strahlung im aktiven Bereich des Halbleiterchips überwiegend in lateralen Bereichen erzeugt, in denen in vertikale Richtung emittierte Strahlung nicht von einem darüber liegenden Kontakt absorbiert wird, sondern aus dem Halbleiterchip austreten kann. Die Auskoppeleffizienz des Halbleiterchips kann so gesteigert werden.

In einer bevorzugten Ausgestaltung ist die Injektionsbarriere in ihrer lateralen Formgebung an eine laterale Formgebung des Kontakts angepasst. In einer Aufsicht auf den Halbleiterchip kann also die Injektionsbarriere mit dem Kontakt, vorzugsweise vollständig, überlappen. Weiterhin weist die Injektionsbarriere in Aufsicht vorzugsweise die selbe geometrische Grundform auf wie der Kontakt.

Unter einer lateralen Richtung wird hierbei eine Richtung verstanden, die sich entlang einer Haupterstreckungsrichtung der Halbleiterschichten der Halbleiterschichtenfolge erstreckt. Entsprechend verläuft eine vertikale Richtung senkrecht zur Haupterstreckungsrichtung dieser Halbleiterschichten.

In einer Ausgestaltungsvariante ist die Injektionsbarriere an einer Grenzfläche zwischen dem Kontakt und dem Halbleiterkörper ausgebildet. In diesem Fall kann die Injektionsbarriere mittels einer Potential-Barriere, insbesondere mittels eines Schottky-Kontakts, also eines Metall-Halbleiter-Übergangs, zwischen dem Kontakt und dem Halbleiterkörper abgebildet sein.

Weitergehend kann die Injektionsbarriere in einer Ausnehmung im Halbleiterkörper ausgebildet sein. Mittels der Ausnehmung kann beispielsweise Material des Halbleiterkörpers, das zum Kontakt einen vergleichsweise geringen Kontaktwiderstand aufweist, entfernt sein. Dadurch kann Material des Halbleiterkörpers freigelegt sein, das einen höheren Kontaktwiderstand zu dem Kontakt aufweist. Auf diese Weise kann der in der Ausnehmung angeordnete Kontakt in vertikaler Richtung einen höheren Kontaktwiderstand zum Halbleiterkörper aufweisen als in lateraler Richtung. Auf diese Weise wird eine direkte vertikale Injektion von Ladungsträgern vom Kontakt in den aktiven Bereich vermindert.

An dieser Stelle sei angemerkt, dass ein fertigungsbedingt nicht völlig vermeidbarer Kontaktwiderstand, insbesondere ein ohmscher Kontaktwiderstand mit einer linearen oder zumindest näherungsweise linearen Strom-Spannungs-Kennlinie, zwischen einem Metallkontakt und einer Halbleiterschicht nicht als Injektionsbarriere im Sinne der vorliegenden Erfindung angesehen wird. Vielmehr ist die Injektionsbarriere vorzugsweise so ausgebildet, dass im Betrieb des Halbleiterchips mittels einer externen elektrischen Spannung in den Kontakt eingeprägte Ladungsträger in Aufsicht auf den Halbleiterchip im Bereich der Injektionsbarriere nicht oder zumindest mit einer sehr viel niedrigeren Wahrscheinlichkeit in den aktiven Bereich injiziert werden, als außerhalb der Injektionsbarriere. Hierbei weist die Injektionsbarriere eine geringere laterale Ausdehnung auf als der aktive Bereich.

In einer alternativen Ausgestaltungsvariante ist die Injektionsbarriere im Halbleiterkörper ausgebildet. Vorzugsweise ist die Injektionsbarriere mittels eines Bereichs gebildet, in dem eine elektrische Leitfähigkeit einer zwischen dem aktiven Bereich und dem Kontakt angeordneten Halbleiterschicht lokal verringert ist. Die Leitfähigkeit der Halbleiterschicht ist also in diesem Bereichs geringer als außerhalb dieses Bereichs. Mit anderen Worten ist die Leitfähigkeit in diesem Bereich verglichen mit einem lateral benachbarten Bereich der Halbleiterschicht verringert. Weiterhin ist dieser Bereich geringerer Leitfähigkeit in lateraler Richtung vorzugsweise inselartig ausgebildet und ist in seiner lateralen Formgebung besonders bevorzugt an die laterale Formgebung des Kontakts angepasst.

Der Bereich, in dem die Leitfähigkeit verringert ist, kann in vertikaler Richtung vom Kontakt beabstandet sein. In diesem Fall können Ladungsträger im Betrieb des Halbleiterchips direkt in vertikaler Richtung vom Kontakt in den Halbleiterkörper injiziert werden. Eine weitergehende direkte vertikale Injektion in den aktiven Bereich wird aufgrund dieses Bereichs geringer elektrischer Leitfähigkeit verhindert oder zumindest zugunsten einer gesteigerten Injektion außerhalb dieses Bereichs vermindert. Die Auskoppeleffizienz des Halbleiterkörpers kann so gesteigert werden.

In einer weiteren alternativen Ausgestaltungsvariante ist die Injektionsbarriere außerhalb des Halbleiterkörpers ausgebildet. Bevorzugt ist die Injektionsbarriere mittels einer Isolationsschicht gebildet, die zwischen dem Halbleiterkörper und dem Kontakt angeordnet ist. Weitergehend kann zwischen dem Halbleiterkörper und dem Kontakt eine Mehrzahl von Isolationsschichten ausgebildet sein. Besonders bevorzugt ist die Mehrzahl von Isolationsschichten gemäß einem Bragg-Spiegel ausgebildet.

In einer bevorzugten Weiterbildung ist mittels der Isolationsschicht ein dielektrischer Spiegel gebildet.

Die Injektionsbarriere kann also zusätzlich die Funktion eines Spiegels für im aktiven Bereich erzeugte Strahlung erfüllen. Absorption dieser Strahlung in dem Kontakt kann so stark verringert werden. Die an der Injektionsbarriere, insbesondere an dem dielektrischen Spiegel, reflektierte Strahlung kann nachfolgend aus dem Halbleiterchip austreten. Die Auskoppeleffizienz des Halbleiterchips kann somit weitergehend gesteigert werden.

In einer bevorzugten Ausgestaltung weist der Kontakt eine Kontaktschicht auf, die den Kontakt auf der dem Halbleiterkörper abgewandten Seite abschließt. Die Kontaktschicht dient insbesondere der externen Kontaktierung des Halbleiterchips, beispielsweise mittels eines Bond-Drahts. Die Kontaktschicht enthält vorzugsweise ein Metall, etwa Au, Ti, Pt oder Ni, oder eine metallische Legierung mit zumindest einem dieser Materialien.

Weiterhin bevorzugt weist der Kontakt eine Spiegelschicht auf, die zwischen der Kontaktschicht und dem Halbleiterkörper angeordnet ist. Die Spiegelschicht weist vorzugsweise für im aktiven Bereich erzeugte Strahlung eine hohe Reflektivität auf. Die Spiegelschicht enthält vorzugsweise ein Metall, etwa Gold, Aluminium, Silber, Palladium oder Rhodium oder eine metallische Legierung, die zumindest eines der genannten Metalle enthält. Mittels der Spiegelschicht kann eine Absorption von im aktiven Bereich erzeugter Strahlung in der Kontaktschicht vermieden werden. Die Auskoppeleffizienz des Halbleiterchips kann dadurch gesteigert werden.

Die Kontaktschicht kann in lateraler Richtung zumindest bereichsweise über die Spiegelschicht hinaus ragen. Insbesondere kann die Kontaktschicht die Spiegelschicht in lateraler Richtung überformen, das heißt die Kontaktschicht bedeckt die Spiegelschicht auch an zumindest einer Seitenfläche. Auf diese Weise kann eine direkte Injektion von Ladungsträgern von der Kontaktschicht in eine in lateraler Richtung an die Kontaktschicht angrenzende Schicht vereinfacht werden. Die Spiegelschicht leistet in diesem Fall keinen oder zumindest keinen wesentlichen Beitrag zur Injektion von Ladungsträgern vom Kontakt in den Halbleiterkörper.

Weitergehend kann die Spiegelschicht auf der dem aktiven Bereich abgewandten Seite der Isolationsschicht beziehungsweise der Mehrzahl von Isolationsschichten angeordnet sein. Auf diese Weise kann von den Isolationsschichten transmittierte Strahlung an der Spiegelschicht reflektiert werden. Ein Spiegelverbund mit hoher Gesamtreflektivität für im aktiven Bereich erzeugte Strahlung kann auf diese Weise vereinfacht gebildet sein.

In einer bevorzugten Ausgestaltung weist der Halbleiterchip eine Stromverbreiterungsschicht auf, die mit dem Kontakt elektrisch leitend verbunden ist. Die Stromverbreiterungsschicht ist im Betrieb des Halbleiterchips dafür vorgesehen, Ladungsträger in Aufsicht auf den Halbleiterchip außerhalb der Injektionsbarriere in den aktiven Bereich zu injizieren.

Die Stromverbreiterungsschicht weist im Vergleich zum Kontakt vorzugsweise eine große laterale Ausdehnung auf. Besonders bevorzugt grenzt die Stromverbreiterungsschicht an eine den aktiven Bereich in lateraler Richtung begrenzende Seitenfläche des Halbleiterkörpers an. Eine großflächige Einprägung von Ladungsträgern in den aktiven Bereich wird dadurch vereinfacht.

In einer bevorzugten Ausgestaltung weist die Stromverbreiterungsschicht eine Ausnehmung auf, in der der Kontakt angeordnet ist. Die Ausnehmung kann sich auch in vertikaler Richtung durch die Stromverbreiterungsschicht hindurch erstrecken. Eine vertikale Injektion von Ladungsträgern vom Kontakt in die Stromverbreiterungsschicht kann so vermindert werden.

Die Stromverbreiterungsschicht und der Kontakt können hierbei zumindest bereichsweise in lateraler Richtung aneinander angrenzen. Ladungsträger können so in lateraler Richtung unmittelbar vom Kontakt in die Stromverbreiterungsschicht injiziert werden.

Alternativ können die Stromverbreiterungsschicht und der Kontakt lateral voneinander beabstandet sein. In diesem Fall sind die Stromverbreiterungsschicht und der Kontakt vorzugsweise mittels einer Schicht elektrisch leitend verbunden, die zwischen dem Kontakt und dem aktiven Bereich angeordnet ist.

In einer weiteren bevorzugten Ausgestaltung ist die Stromverbreiterungsschicht nichtmetallisch. Weiterhin ist die Stromverbreiterungsschicht vorzugsweise mittels eines Materials gebildet, das für die im aktiven Bereich erzeugte Strahlung durchlässig ist. Die Stromverteilungsschicht kann also nichtmetallisch und für im aktiven Bereich erzeugte Strahlung durchlässig sein.

Unter einer nichtmetallischen Stromverbreiterungsschicht wird im Rahmen der Erfindung eine Schicht oder Schichtenfolge verstanden, wobei die Schicht beziehungsweise die einzelnen Schichten der Schichtenfolge zwar ein Metall enthalten können, aber keine metallischen Eigenschaften aufweisen.

Insbesondere kann die nichtmetallische Stromverbreiterungsschicht auf Halbleitermaterial basieren oder aus Halbleitermaterial bestehen. Die Stromverbreiterungsschicht kann also im Halbleiterkörper ausgebildet sein. Hierbei ist die Stromverbreiterungsschicht vorzugsweise eine Halbleiterschicht, die bezüglich ihres Leitungstyps von einer weiteren Halbleiterschicht, die zwischen der Halbleiterschicht und dem aktiven Bereich angeordnet ist, verschieden ist.

Alternativ kann die Stromverbreiterungsschicht außerhalb des Halbleiterkörpers angeordnet sein. Vorzugsweise enthält eine außerhalb des Halbleiterkörpers angeordnete Stromverbreiterungsschicht ein TCO-Material (transparent conductive oxide).

TCO-Materialien sind transparente, leitende Oxide, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

In einer weiteren bevorzugten Ausgestaltung ist zwischen der Stromverbreiterungsschicht und dem Halbleiterkörper eine Anschlussschicht angeordnet. Die Anschlussschicht enthält zweckmäßigerweise ein Material, mit dem eine elektrisch leitende Verbindung zu einer Halbleiterschicht mit geringem Kontaktwiderstand herstellbar ist. Vorzugsweise enthält die Anschlussschicht ein Metall, etwa Titan, Platin, Nickel, Rhodium oder eine metallische Legierung mit zumindest einem der genannten Materialien. Weiterhin bevorzugt ist die Anschlussschicht hinreichend dünn ausgeführt, so dass sie für im aktiven Bereich erzeugte Strahlung zumindest teiltransparent ist. Besonders bevorzugt beträgt die Dicke der Anschlussschicht höchstens 10 nm.

In einer weiteren bevorzugten Ausgestaltung ist zwischen der Stromverbreiterungsschicht und dem aktiven Bereich eine Tunnelkontaktschicht angeordnet. Die Tunnelkontaktschicht ist bezüglich ihres Leitungstyps von einer weiteren Halbleiterschicht, die zwischen der Tunnelkontaktschicht und dem aktiven Bereich angeordnet ist, verschieden. Die Tunnelkontaktschicht ist vorzugsweise eine hoch dotierte Halbleiterschicht. Bevorzugt beträgt die Dotierkonzentration mindestens 10¹⁸cm⁻³, besonders bevorzugt mindestens 10¹⁹cm⁻³.

Mittels der Tunnelkontaktschicht kann die Injektion von Ladungsträgern von der Stromverbreiterungsschicht in den aktiven Bereich vereinfacht werden.

In einer bevorzugten Weiterbildung ist auf der dem aktiven Bereich zugewandten Seite der Tunnelkontaktschicht eine weitere Tunnelkontaktschicht angeordnet. Die weitere Tunnelkontaktschicht weist einen anderen Leitungstyp auf als die Tunnelkontaktschicht. Ferner weist die weitere Tunnelkontaktschicht vorzugsweise ebenfalls eine hohe Dotierkonzentration auf.

In einer weiteren bevorzugten Weiterbildung ist die Injektionsbarriere mittels eines Bereichs der weiteren Tunnelkontaktschicht gebildet, in dem die elektrische Leitfähigkeit lokal verringert ist. In diesem Fall ist die Injektionsbarriere also im Halbleiterkörper ausgebildet. Weiterhin kann die Tunnelkontaktschicht zwischen dem Kontakt und der weiteren Tunnelkontaktschicht ausgebildet sein. Der Bereich lokal verringerter Leitfähigkeit kann also vom Kontakt in vertikaler Richtung beabstandet sein. Im Betrieb des Halbleiterchips können so Ladungsträger vom Kontakt in die Tunnelkontaktschicht gelangen und sich in lateraler Richtung ausbreiten. Das Ausbreiten der Ladungsträger in lateraler Richtung kann weiterhin mittels der, innerhalb oder außerhalb des Halbleiterkörpers angeordneten, Stromverbreiterungsschicht gefördert werden. Von der Tunnelkontaktschicht können die Ladungsträger nachfolgend außerhalb des Bereichs lokal verringerter elektrischer Leitfähigkeit über die weitere Tunnelkontaktschicht in den aktiven Bereich injiziert werden.

Die Tunnelkontaktschicht und/oder die weitere Tunnelkontaktschicht können vergleichsweise dünn ausgeführt sein. Die Dicke kann 100 nm oder weniger, bevorzugt 20 nm oder weniger, besonders bevorzugt 10 nm oder weniger betragen.

In einer bevorzugten Ausgestaltung ist die Stromverbreiterungsschicht als eine Tunnelkontaktschicht ausgeführt. Die Stromverbreiterungsschicht ist also eine hoch dotierte Halbleiterschicht und somit Teil des Halbleiterkörpers. Auf weitere, außerhalb des Halbleiterkörpers angeordnete, Schichten zur Stromverteilung und zur in lateraler Richtung gleichmäßigen Einprägung von Ladungsträgern in den aktiven Bereich kann in diesem Fall verzichtet werden.

Auf der dem aktiven Bereich zugewandten Seite der Tunnelkontaktschicht kann wiederum eine weitere Tunnelkontaktschicht angeordnet sein, wobei die weitere Tunnelkontaktschicht einen anderen Leitungstyp aufweist als die Tunnelkontaktschicht.

Der Halbleiterchip ist bevorzugt zur Erzeugung von inkohärenter oder überwiegend inkohärenter Strahlung vorgesehen. Beispielsweise kann der Halbleiterchip als ein LED-Chip oder weitergehend als RCLED-Chip (resonant cavity light emitting) ausgeführt sein. Bei einem RCLED-Chip ist der aktive Bereich innerhalb einer Kavität angeordnet.

Der Halbleiterchip kann auch zur Erzeugung von kohärenter Strahlung vorgesehen sein. Hierbei kann der Halbleiterchip als ein Halbleiterlaserchip, insbesondere als ein oberflächenemittierender Halbleiterlaserchip mit internem Resonator (vertical cavity surface emitting laser, VCSEL)oder als oberflächenemittierender Halbleiterchip zum Betrieb mit einem externen Resonator (vertical external cavity surface emitting laser, VECSEL) ausgeführt sein.

Der Halbleiterkörper, insbesondere der aktive Bereich, enthält bevorzugt ein III-V-Halbleitermaterial. Mittels III-V-Halbleitermaterialien kann Strahlung vom infraroten bis zum ultravioletten Spektralbereich mit hoher Effizienz erzeugt werden.

Der Halbleiterchip, insbesondere der Halbleiterkörper, kann auch mehr als einen aktiven Bereich aufweisen, etwa zwei oder mehr übereinander angeordnete aktive Bereiche. In diesem Fall bezieht sich die Anordnung der oben genannten Elemente des Halbleiterchips, insbesondere der Stromverbreiterungsschicht, der Tunnelkontaktschicht, der weiteren Tunnelkontaktschicht und der Anschlussschicht, relativ zum aktiven Bereich auf denjenigen aktiven Bereich, der am nächsten zum Kontakt angeordnet ist.

Gemäß einer Ausführungsform wird bei einem erfindungsgemäßen Verfahren zur Herstellung eines Halbleiterchips, der einen Halbleiterkörper mit einer Halbleiterschichtenfolge umfasst, die einen zur Erzeugung von Strahlung vorgesehenen aktiven Bereich aufweist, ein Kontakt auf dem Halbleiterkörper aufgebracht. Zwischen dem aktiven Bereich und dem Kontakt ist eine Injektionsbarriere gebildet.

In einer bevorzugten Ausgestaltung wird die Injektionsbarriere im Halbleiterkörper ausgebildet. Dies erfolgt insbesondere vor dem Aufbringen des Kontakts auf dem Halbleiterkörper. Bevorzugt wird die Injektionsbarriere im Halbleiterkörper mittels eines Bereichs einer Halbleiterschicht gebildet, in dem die eine elektrische Leitfähigkeit der Halbleiterschicht lokal verringert wird.

Diese lokale Verringerung der elektrischen Leitfähigkeit der Halbleiterschicht kann beispielsweise durch eine Kompensation der Dotierung, etwa durch gezielte Störung der Kristallstruktur, erfolgen. Beispielsweise können gezielt erzeugte Kristalldefekte in einer ursprünglich p-dotierten Halbleiterschicht zu einer vollständigen oder zumindest teilweisen Kompensation der p-Dotierung führen. Die durch die Akzeptoren der p-leitenden Halbleiterschicht bedingte elektrische Leitfähigkeit wird hierbei durch die Störstellen, die als Donator wirken, verringert. Dies kann beispielsweise mittels Rücksputterns erzielt werden. Beim Rücksputtern wird vorzugsweise ein Ionenstrahl, etwa ein Ar-Ionenstrahl, auf die Halbleiterschicht gerichtet.

Die lokale Verringerung der elektrischen Leitfähigkeit kann auch durch eine zumindest teilweise Deaktivierung der Donatoren beziehungsweise Akzeptoren erzielt werden.

So kann etwa durch ein Wasserstoff-Plasma Wasserstoff in die p-leitende Halbleiterschicht eingebracht werden. Akzeptoren, etwa Mg-Akzeptoren in einer p-leitend dotierten, auf InGaAlN basierenden Halbleiterschicht, können so elektrisch deaktiviert werden.

Auch durch eine Implantation von Ionen mit zur Halbleiterschicht entgegengesetztem Ladungstyp kann die elektrische Leitfähigkeit verringert werden.

In einer weiteren bevorzugten Ausgestaltung wird auf den Halbleiterkörper eine Stromverbreiterungsschicht, beispielsweise mittels Sputterns oder Aufdampfens, aufgebracht. Auf der Stromverbreiterungsschicht kann eine lateral strukturierte Maskierungsschicht ausgebildet oder angeordnet werden. Nachfolgend kann in einem von der Maskierungsschicht freien Bereich Material der Stromverbreiterungsschicht und des Halbleiterkörpers entfernt werden. Die Lateralstrukturierung der Stromverbreiterungsschicht und des Halbleiterkörpers kann also mittels einer gemeinsamen Maskierungsschicht erfolgen. Auf eine zusätzliche Maskierungsschicht kann also verzichtet werden. Dadurch können die Herstellungskosten verringert werden. Weiterhin kann dadurch die Strukturierungsgenauigkeit gesteigert werden.

In einer bevorzugten Weiterbildung wird auf der Stromverbreiterungsschicht eine weitere lateral strukturierte Maskierungsschicht ausgebildet. Dies erfolgt vorzugsweise nach dem Entfernen der Maskierungsschicht.

In einem von der weiteren Maskierungsschicht freien weiteren Bereich kann eine Ausnehmung in der Stromverbreiterungsschicht ausgebildet werden. In der Ausnehmung können eine Spiegelschicht und nachfolgend eine Kontaktschicht aufgebracht werden.

Die Abscheidebedingungen bei der Herstellung der Spiegelschicht und der Kontaktschicht können derart eingestellt werden, dass die Kontaktschicht in lateraler Richtung über die Spiegelschicht hinaus ragt. Beispielsweise kann die Spiegelschicht aus senkrechter oder im wesentlichen senkrechter Richtung auf dem Halbleiterkörper abgeschieden werden, während die Kontaktschicht schräg bei gleichzeitiger Rotation des Halbleiterkörpers abgeschieden wird. Dadurch kann erreicht werden, dass die Kontaktschicht eine größere laterale Ausdehnung aufweist als die Spiegelschicht, ohne dass hierfür verschiedene Maskierungsschichten erforderlich werden.

Weiterhin kann der Kontakt oder zumindest eine Schicht des Kontakts, etwa die Kontaktschicht oder die Spiegelschicht, derart in der Ausnehmung der Stromverbreiterungsschicht ausgebildet werden, dass der Kontakt in lateraler Richtung von der Stromverbreiterungsschicht beabstandet ist. Dies kann mittels der selben weiteren Maskierungsschicht erfolgen. Beispielsweise kann die Ausnehmung in der Stromverbreiterungsschicht mittels nasschemischen Ätzens ausgebildet werden. Die Ausnehmung in der Stromverbreiterungsschicht kann so eine größere laterale Ausdehnung annehmen als die Aussparung in der weiteren Maskierungsschicht. Nachfolgend kann der Kontakt oder zumindest eine Schicht des Kontakts so abgeschieden werden, dass die laterale Ausdehnung des Kontakts oder der zumindest einen Schicht des Kontakts kleiner oder gleich der lateralen Ausdehnung der Aussparung in der weiteren Maskierungsschicht ist. Dies kann durch Abscheidung aus senkrechter oder im wesentlichen senkrechter Richtung erfolgen. So kann ein Zwischenraum zwischen dem Kontakt oder der zumindest einen Schicht des Kontakts ausgebildet werden.

Die Herstellung der auf dem Halbleiterkörper angeordneten Schichten, insbesondere der Stromverbreiterungsschicht, der Kontaktschicht, der Spiegelschicht und der Anschlussschicht, erfolgt vorzugsweise mittels Aufdampfens oder Aufsputterns.

Das beschriebene Verfahren ist zur Herstellung eines weiter oben beschriebenen Halbleiterchips besonders geeignet. Im Zusammenhang mit dem Halbleiterchip ausgeführte Merkmale können daher auch für das Verfahren herangezogen werden und umgekehrt.

Der Halbleiterchip beziehungsweise das Verfahren können sich insbesondere durch mindestens einen der folgenden Aspekte auszeichnen, welche zur vereinfachten Darstellung nummeriert und mit Rückbezügen versehen sind.
1. Halbleiterchip, umfassend einen Halbleiterkörper mit einer Halbleiterschichtenfolge, die einen zur Erzeugung von Strahlung vorgesehenen aktiven Bereich aufweist, wobei auf dem Halbleiterkörper ein Kontakt angeordnet ist und zwischen dem Kontakt und dem aktiven Bereich eine Injektionsbarriere ausgebildet ist.
2. Halbleiterchip nach Aspekt 1,
   bei dem die Injektionsbarriere mittels einer Potential-Barriere an einer Grenzfläche zwischen dem Kontakt und dem Halbleiterkörper ausgebildet ist.
3. Halbleiterchip nach Aspekt 1,
   bei dem die Injektionsbarriere im Halbleiterkörper ausgebildet ist, wobei die Injektionsbarriere mittels eines Bereichs gebildet ist, in dem eine elektrische Leitfähigkeit einer zwischen dem aktiven Bereich und dem Kontakt angeordneten Halbleiterschicht lokal verringert ist.
4. Halbleiterchip nach Aspekt 1,
   bei dem die Injektionsbarriere außerhalb des
   Halbleiterkörpers ausgebildet ist, wobei die
   Injektionsbarriere mittels einer Isolationsschicht gebildet ist, die zwischen dem Halbleiterkörper und dem Kontakt angeordnet ist.
5. Halbleiterchip nach einem der vorhergehenden Aspekte, bei dem der Kontakt eine Kontaktschicht aufweist, die den Kontakt auf der dem Halbleiterkörper abgewandten Seite abschließt und bei dem der Kontakt eine Spiegelschicht aufweist, die zwischen der Kontaktschicht und dem Halbleiterkörper angeordnet ist,
   wobei die Kontaktschicht in lateraler Richtung zumindest bereichsweise über die Spiegelschicht hinausragt.
6. Halbleiterchip nach einem der vorhergehenden Aspekte, der eine Stromverteilungsschicht aufweist, die mit dem Kontakt elektrisch leitend verbunden ist und die im Betrieb des Halbleiterchips in lateraler Richtung außerhalb der Injektionsbarriere zur Injektion von Ladungsträgern in den aktiven Bereich vorgesehen ist.
7. Halbleiterchip nach Aspekt 6,
   bei dem die Stromverteilungsschicht eine Ausnehmung aufweist, in der der Kontakt angeordnet ist, wobei die
   Stromverteilungsschicht und der Kontakt zumindest bereichsweise aneinander angrenzen.
8. Halbleiterchip nach Aspekt 6,
   bei dem die Stromverteilungsschicht eine Ausnehmung aufweist, wobei die Stromverteilungsschicht und der Kontakt lateral voneinander beabstandet sind.
9. Halbleiterchip nach einem der Aspekte 6 bis 8,
   bei dem die Stromverteilungsschicht ein TCO-Material enthält.
10. Halbleiterchip nach Aspekt 9,
   bei dem zwischen der Stromverteilungsschicht und dem Halbleiterkörper eine Anschlussschicht angeordnet ist, die ein Metall oder eine metallische Legierung enthält.
11. Halbleiterchip nach einem der Aspekte 6 bis 10,
   bei dem
   - zwischen der Stromverteilungsschicht und dem aktiven Bereich eine Tunnelkontaktschicht angeordnet ist, wobei die Tunnelkontaktschicht bezüglich ihres Leitungstyps von einer weiteren Halbleiterschicht, die zwischen der Tunnelkontaktschicht und dem aktiven Bereich angeordnet ist, verschieden ist;
   - auf der dem aktiven Bereich zugewandten Seite der Tunnelkontaktschicht eine weitere Tunnelkontaktschicht angeordnet ist, wobei die weitere Tunnelkontaktschicht einen anderen Leitungstyp aufweist als die Tunnelkontaktschicht; und
   - die Injektionsbarriere mittels eines Bereichs der weiteren Tunnelkontaktschicht ausgebildet ist, in dem die elektrische Leitfähigkeit lokal verringert ist.
12. Halbleiterchip nach einem der Aspekte 6 bis 8,
   bei dem
   - die Stromverteilungsschicht eine Halbleiterschicht ist, die bezüglich ihres Leitungstyps von einer weiteren Halbleiterschicht, die zwischen der Stromverteilungsschicht und dem aktiven Bereich angeordnet ist, verschieden ist;
   - die Stromverteilungsschicht als eine Tunnelkontaktschicht ausgebildet ist und auf der dem aktiven Bereich zugewandten Seite der Tunnelkontaktschicht eine weitere Tunnelkontaktschicht angeordnet ist, wobei die weitere Tunnelkontaktschicht einen anderen Leitungstyp aufweist als die Tunnelkontaktschicht; und
   - die Injektionsbarriere mittels eines Bereichs der weiteren Tunnelkontaktschicht gebildet ist, in dem die elektrische Leitfähigkeit lokal verringert ist.
13. Verfahren zur Herstellung eines Halbleiterchips, umfassend einen Halbleiterkörper mit einer Halbleiterschichtenfolge, die einen zur Erzeugung von Strahlung vorgesehenen aktiven Bereich aufweist, bei dem auf dem Halbleiterkörper ein Kontakt aufgebracht wird, wobei zwischen dem aktiven Bereich und dem Kontakt eine Injektionsbarriere gebildet ist.
14. Verfahren nach Aspekt 13,
   bei dem die Injektionsbarriere mittels eines Bereichs einer Halbleiterschicht gebildet wird, in dem eine elektrische Leitfähigkeit der Halbleiterschicht mittels Ionen-Implantation lokal verringert wird.
15. Verfahren nach Aspekt 13,
   bei dem die Injektionsbarriere mittels eines Bereichs einer Halbleiterschicht gebildet wird, in dem eine elektrische Leitfähigkeit der Halbleiterschicht mittels eines Plasmaverfahrens und/oder mittels Rücksputterns lokal verringert wird.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.

Es zeigen:
Figur 1 ein erstes Ausführungsbeispiel für einen erfindungsgemäßen Halbleiterchip in schematischer Schnittansicht,
Figur 2 ein zweites Ausführungsbeispiel für einen erfindungsgemäßen Halbleiterchip in schematischer Schnittansicht,
Figur 3 ein drittes Ausführungsbeispiel für einen erfindungsgemäßen Halbleiterchip in schematischer Schnittansicht,
Figur 4 ein viertes Ausführungsbeispiel für einen erfindungsgemäßen Halbleiterchip in schematischer Schnittansicht,
Figur 5 ein fünftes Ausführungsbeispiel für einen erfindungsgemäßen Halbleiterchip in schematischer Schnittansicht,
Figuren 6A bis 6E ein erstes Ausführungsbeispiel für ein erfindungsgemäßes Herstellungsverfahren anhand einiger Zwischenschritte in schematischer Schnittansicht,
Figuren 7A bis 7E ein zweites Ausführungsbeispiel für ein erfindungsgemäßes Herstellungsverfahren anhand einiger Zwischenschritte in schematischer Schnittansicht, und
Figuren 8A bis 8E ein drittes Ausführungsbeispiel für ein erfindungsgemäßes Herstellungsverfahren anhand einiger Zwischenschritte in schematischer Schnittansicht.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente, insbesondere dünne Schichten, zur Verdeutlichung übertrieben groß dargestellt sein.

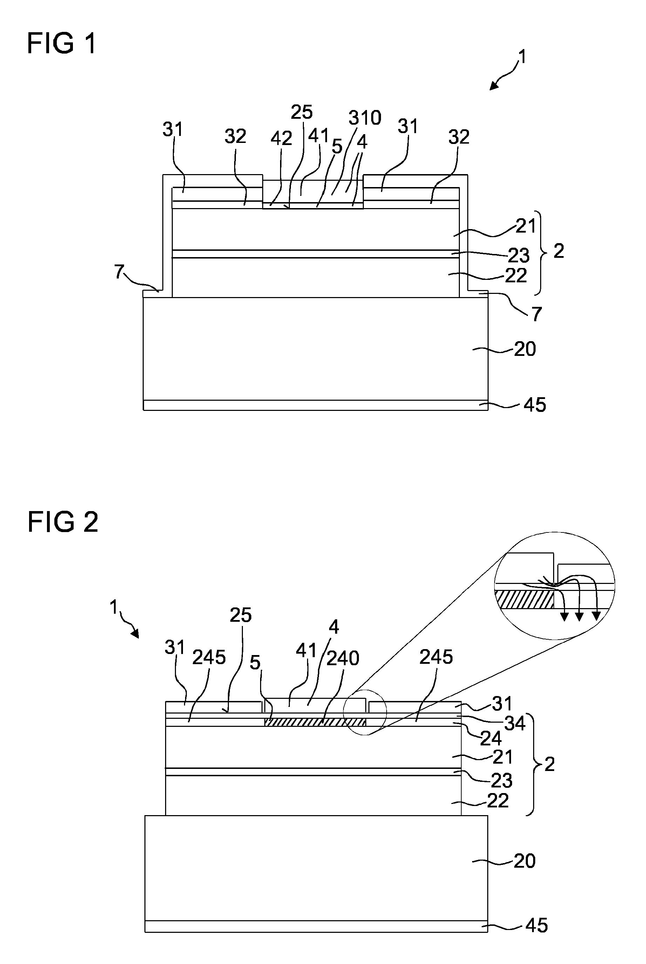

Ein erstes Ausführungsbeispiel für einen erfindungsgemäßen Halbleiterchip ist in Figur 1 schematisch in Schnittansicht dargestellt. Der Halbleiterchip 1 weist einen Halbleiterkörper 2 mit einer Halbleiterschichtenfolge auf. Die Halbleiterschichtenfolge bildet den Halbleiterkörper. Der Halbleiterkörper weist einen aktiven Bereich 23 auf, der zwischen einer p-leitenden Halbleiterschicht 21 und einer n-leitenden Halbleiterschicht 22 angeordnet ist.

Der Halbleiterkörper 2 ist auf einem Träger 20 angeordnet. Der Träger 20 kann beispielsweise ein Aufwachssubstrat für die Halbleiterschichtenfolge des Halbleiterkörpers 2 sein. Beispielsweise kann der Träger einen Halbleiter, etwa Si, Ge, GaAs, SiC, GaN oder GaP enthalten oder aus einem solchen Material bestehen. Alternativ kann beispielsweise auch ein Träger, der Saphir enthält oder aus Saphir besteht, Anwendung finden. Zur Steigerung der elektrischen Leitfähigkeit kann der Träger geeignet dotiert sein. Die Halbleiterschichtenfolge des Halbleiterkörpers 2 ist vorzugsweise epitaktisch, etwa mittels MBE oder MOVPE, auf dem Aufwachssubstrat abgeschieden.

Auf dem Halbleiterkörper 2 ist ein Kontakt 4 angeordnet. Der Kontakt ist auf der dem Träger 20 gegenüberliegenden Seite des aktiven Bereichs 23 angeordnet und kann beispielsweise eine kreisförmige oder rechteckige Grundform aufweisen. Der Kontakt 4 weist eine Kontaktschicht 41 und eine Spiegelschicht 42 auf. Die Spiegelschicht ist zwischen der Kontaktschicht und dem Halbleiterkörper 2 angeordnet. Zwischen dem Kontakt 4 und dem Halbleiterkörper 2 ist eine Injektionsbarriere 5 ausgebildet.

Die Injektionsbarriere ist an einer Grenzfläche 25 des Halbleiterkörpers 2 ausgebildet, die den Halbleiterkörper in vertikaler Richtung auf der dem Träger 20 abgewandten Seite begrenzt. Die Injektionsbarriere ist als ein Schottky-Kontakt zwischen dem Kontakt 4 und dem Halbleiterkörper 2, insbesondere als Schottky-Kontakt zwischen der Spiegelschicht 42 und der p-leitenden Halbleiterschicht 21 ausgeführt. Die laterale Ausdehnung der Injektionsbarriere 5 entspricht hierbei der lateralen Ausdehnung des Kontakts 4.

Weiterhin ist auf dem Halbleiterkörper 2 eine Stromverbreiterungsschicht 31 angeordnet. Die Stromverbreiterungsschicht 31 ist auf derselben Seite des Halbleiterkörpers 2 angeordnet wie der Kontakt 4. Dabei ist die laterale Ausdehnung der Stromverbreiterungsschicht groß im Vergleich zu derjenigen des Kontakts 4. Die Stromverbreiterungsschicht 31 weist eine Ausnehmung 310 auf.

Die Ausnehmung erstreckt sich vorzugsweise in vertikaler Richtung durch die Stromverbreiterungsschicht 31 hindurch. In dieser Aussparung ist der Kontakt 4, insbesondere die Kontaktschicht 41, angeordnet.

Der Kontakt 4 und die Stromverbreiterungsschicht 31, insbesondere die Kontaktschicht 41 und die Stromverbreiterungsschicht 31, grenzen in lateraler Richtung aneinander an. Im Betrieb des Halbleiterchips in die Kontaktschicht 41 injizierte Ladungsträger können somit in lateraler Richtung direkt von der Kontaktschicht in die Stromverbreiterungsschicht 31 gelangen. Von der Stromverbreiterungsschicht 31 können die Ladungsträger in vertikaler Richtung in den Halbleiterkörper, insbesondere in den aktiven Bereich 23, injiziert werden. Eine direkte vertikale Injektion von der Kontaktschicht 41 in den Halbleiterkörper 2 ist dagegen mittels der Injektionsbarriere 5 erschwert. In Aufsicht auf den Halbleiterchip 1 wird somit Strahlung im aktiven Bereich überwiegend außerhalb der Injektionsbarriere 5 erzeugt. Die Auskoppeleffizienz des Halbleiterchips 1 kann dadurch gesteigert werden.

Die Stromverbreiterungsschicht 31 ist vorzugsweise nichtmetallisch ausgeführt und ist weiterhin bevorzugt für im aktiven Bereich erzeugte Strahlung durchlässig ausgebildet. Die Stromverbreiterungsschicht 31 enthält vorzugsweise ein TCO-Material, beispielsweise Indium-Zinnoxid (ITO) oder Zinkoxid (ZnO). Auch ein weiter oben genanntes TCO-Material kann für die Stromverbreiterungsschicht 31 geeignet sein.

Zwischen der Stromverbreiterungsschicht 31 und dem Halbleiterkörper 2 ist eine Anschlussschicht 32 ausgebildet. Mittels der Anschlussschicht 32 können Ladungsträger vereinfacht von der Stromverbreiterungsschicht 31 in den Halbleiterkörper 2 injiziert werden. Aufgrund der Anschlussschicht können für die Stromverbreiterungsschicht also auch Materialien verwendet werden, mit denen ein niedriger, insbesondere ohmscher, Kontaktwiderstand zum Halbleiterkörper 2 nicht oder nur schwer realisierbar ist. Bei einem hinreichend guten elektrischen Kontakt zwischen der Stromverbreiterungsschicht 31 und dem Halbleiterkörper 2 kann auf die Anschlussschicht auch verzichtet werden.

Die Anschlussschicht 32 ist vorzugsweise metallisch ausgeführt oder basiert auf einer metallischen Legierung. Weiterhin ist die Anschlussschicht vorzugsweise derart dünn ausgeführt, dass im aktiven Bereich erzeugte Strahlung durch die Anschlussschicht zumindest teilweise hindurch treten kann.

Die Anschlussschicht kann beispielsweise Titan, Platin, Nickel, Rhodium oder ein anderes Metall mit guten Kontakteigenschaften zu einer Halbleiterschicht enthalten. Alternativ oder ergänzend kann die Anschlussschicht eine metallische Legierung, vorzugsweise mit zumindest einem der genannten Materialien, enthalten. Platin hat sich als besonders vorteilig herausgestellt. Die Dicke der Anschlussschicht beträgt vorzugsweise höchstens 10 nm, beispielsweise 3 bis 7 nm. Beispielsweise weist eine Platinschicht mit einem Dicke von 6 nm im blauen Spektralbereich eine Transmission von etwa 40% auf.

In einer Aufsicht auf den Halbleiterchip 1 überragt die Injektionsbarriere 5 den Kontakt 4 vorzugsweise vollständig. So kann sichergestellt werden, dass im Betrieb des Halbleiterchips 1 in den Kontakt 4 injizierte Ladungsträger aufgrund der Injektionsbarriere nicht oder nur zu einem sehr geringen Anteil direkt in vertikaler Richtung in den Halbleiterkörper 2 injiziert werden. Der überwiegende Teil der Ladungsträger wird von der Kontaktschicht 41 in lateraler Richtung in die Stromverbreiterungsschicht 31 injiziert und gelangt über die Anschlussschicht 32 außerhalb des Injektionsbereichs 5 in die p-leitende Halbleiterschicht 21 und nachfolgend in den aktiven Bereich 23. Somit werden unterhalb des Kontakts 4 vergleichsweise wenig Ladungsträger in den aktiven Bereich 23 injiziert. In einer Aufsicht auf den Halbleiterchip wird im aktiven Bereich Strahlung infolge von Ladungsträgerrekombination also überwiegend außerhalb des Kontakts 4 erzeugt. Der Anteil von Strahlung, der im aktiven Bereich 23 erzeugt und nachfolgend in dem Kontakt 4 absorbiert wird, kann so vermindert werden.

Die Spiegelschicht 42 dient einer weiteren Verminderung von Absorption im Kontakt, insbesondere in der Kontaktschicht 41. Die Spiegelschicht ist zweckmäßigerweise mittels eines Materials gebildet, das für im aktiven Bereich erzeugte Strahlung eine möglichst hohe Reflektivität aufweist. Vorzugsweise ist die Spiegelschicht metallisch ausgeführt oder basiert auf einer metallischen Legierung. Im infraroten und roten Spektralbereich eignet sich beispielsweise Gold, im blauen, grünen und ultravioletten Spektralbereich weisen Aluminium, Silber, Palladium und Rhodium eine vergleichsweise hohe Reflektivität auf.

Mittels der Spiegelschicht 42 kann also eine Absorption von im aktiven Bereich 23 erzeugter Strahlung in der Kontaktschicht 41 vermieden werden. Das Material für die Kontaktschicht 41 kann daher weitgehend unabhängig von den optischen Eigenschaften hinsichtlich einer guten externen Kontaktierbarkeit des Halbleiterchips, etwa mittels eines Bond-Drahts, gewählt werden. Als Material eignet sich insbesondere ein Metall, etwa Gold oder eine metallische Legierung, die beispielsweise Gold enthält, etwa AuSn.

Auf der dem Halbleiterkörper 2 abgewandten Seite des Trägers 20 ist ein weiterer Kontakt 45 angeordnet. Durch Anlegen einer externen elektrischen Spannung zwischen dem Kontakt 4 und dem weiteren Kontakt 45 können Ladungsträger in den aktiven Bereich injiziert werden und dort unter Emission und Strahlung rekombinieren.

Der Halbleiterkörper 2, insbesondere der aktive Bereich 23, enthält bevorzugt ein III-V-Halbleitermaterial. III-V-Halbleitermaterialien sind zur Strahlungserzeugung im ultravioletten (Inₓ Ga_{y} Al_{1-x-y} N) über den sichtbaren (Inₓ Ga_{y} Al_{1-x-y} N, insbesondere für blaue bis grüne Strahlung, oder Inₓ Ga_{y} Al_{1-x-y} P, insbesondere für gelbe bis rote Strahlung) bis in den infraroten (Inₓ Ga_{y} Al_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.
Auf dem Halbleiterkörper 2 ist eine Schutzschicht 7 angeordnet, die den Halbleiterkörper bevorzugt auch an dessen Seitenflächen bedeckt. Diese Schutzschicht dient dem Schutz des Halbleiterkörpers vor schädlichen äußeren Umwelteinflüssen, etwa Feuchtigkeit. Eine solche Schutzschicht ist aber nicht zwingend erforderlich. Die Schutzschicht ist zweckmäßigerweise dielektrisch ausgebildet und enthält bevorzugt ein Oxid, etwa Siliziumoxid, ein Nitrid, etwa Siliziumnitrid, oder ein Oxinitrid, etwa Siliziumoxinitrid.

Die Dotierung der Halbleiterschichten ist in dem Ausführungsbeispiel lediglich beispielhaft angegeben. Insbesondere können die Leitungstypen der Halbleiterschichten davon abweichend invertiert sein, so dass die als n-dotiert beschriebenen Halbleiterschichten p-dotiert und die als p-dotiert beschriebenen Halbleiterschichten n-dotiert sind.

Der Halbleiterchip 1 ist als LED-Halbleiterchip ausgeführt und zur Erzeugung inkohärenter Strahlung vorgesehen. Davon abweichend kann der Halbleiterchip auch als RCLED-Halbleiterchip ausgeführt sein. In einem solchen Halbleiterchip ist der aktive Bereich in einer Kavität angeordnet. Alternativ kann der Halbleiterchip auch zur Erzeugung von kohärenter Strahlung ausgeführt sein. Insbesondere kann der Halbleiterchip ein oberflächenemittierender Halbleiterlaserchip (VCSEL) oder als ein oberflächenemittierender Halbleiterchip zum Betrieb in einem externen Resonator (VECSEL) ausgeführt sein.

Ein zweites Ausführungsbeispiel für einen erfindungsgemäßen Halbleiterchip ist schematisch in Figur 2 dargestellt. Das zweite Ausführungsbeispiel entspricht im wesentlichen dem im Zusammenhang mit Figur 1 beschriebenen ersten Ausführungsbeispiel. Im Unterschied zum ersten Ausführungsbeispiel weist der Halbleiterkörper 2 zusätzlich eine Tunnelkontaktschicht 34 und eine weitere Tunnelkontaktschicht 24 auf. Die Tunnelkontaktschicht und die weitere Tunnelkontaktschicht weisen jeweils eine hohe Ladungsträgerkonzentration, bevorzugt mindestens 10¹⁸cm⁻³, besonders bevorzugt mindestens 10¹⁹cm⁻³, auf.

Weiterhin sind die Tunnelkontaktschicht 34 und die weitere Tunnelkontaktschicht 24 mit zueinander entgegen gesetzten Vorzeichen dotiert. Die Tunnelkontaktschicht 34 weist hierbei einen anderen Leitungstyp auf als die zwischen dem aktiven Bereich 23 und der Tunnelkontaktschicht angeordnete Halbleiterschicht 21. Für den beispielhaft beschriebenen Fall, dass die Halbleiterschicht 21 p-leitend dotiert ist, ist also die Tunnelkontaktschicht 34 n-leitend dotiert. Entsprechend ist die weitere Tunnelkontaktschicht 24 ebenfalls wie die daran angrenzende Halbleiterschicht 21 p-leitend dotiert, wobei die weitere Tunnelkontaktschicht 24 eine höhere Dotierkonzentration aufweist als die Halbleiterschicht 21.

Auf der dem aktiven Bereich 23 abgewandten Seite der Tunnelkontaktschicht ist eine Stromverbreiterungsschicht 31 ausgebildet. Mittels der Tunnelkontaktschicht 34 und der weiteren Tunnelkontaktschicht 24 wird eine Injektion von Ladungsträgern von der Stromverbreiterungsschicht 31 in den Halbleiterkörper 2 vereinfacht. Im Unterschied zu dem im Zusammenhang mit Figur 1 beschriebenen ersten Ausführungsbeispiel erfüllen also Halbleiterschichten die Funktion einer Anschlussschicht. Auf eine zusätzliche, zwischen dem Halbleiterkörper 2 und der Stromverbreiterungsschicht 31 angeordnete, Anschlussschicht kann somit verzichtet werden.

Weiterhin ist im Unterschied zum ersten Ausführungsbeispiel die Injektionsbarriere 5 im Halbleiterkörper 2 ausgebildet. Die Injektionsbarriere 5 ist ein Bereich 240 der weiteren Tunnelkontaktschicht 24. In diesem Bereich weist die weitere Tunnelkontaktschicht 24 eine geringere elektrische Leitfähigkeit auf als in einem lateral benachbarten Bereich 245 der weiteren Tunnelkontaktschicht 24. In einer Aufsicht auf den Halbleiterchip 1 verläuft der Kontakt 4 in lateraler Richtung deckungsgleich oder zumindest im Wesentlichen deckungsgleich mit der Injektionsbarriere 5, also dem Bereich 240 der weiteren Tunnelkontaktschicht 24. Durch eine Injektionsbarriere, die in ihrer Formgebung an diejenige des Kontakts angepasst ist, kann eine Injektion von Ladungsträgern in den aktiven Bereich unterhalb des Kontakts 4 besonders effizient vermindert werden.

Zwischen der Injektionsbarriere 5 und dem Kontakt 4 ist die Tunnelkontaktschicht 34 angeordnet. Der Kontakt 4 und die Injektionsbarriere 5, also der Bereich verringerter elektrischer Leitfähigkeit 240, sind also in vertikaler Richtung voneinander beabstandet. Im Betrieb des Halbleiterchips 1 können Ladungsträger in vertikaler Richtung von dem Kontakt 4 in die Tunnelkontaktschicht 34 injiziert werden. Ein weiter vertikal in Richtung des aktiven Bereichs verlaufender Ladungsträgerfluss wird mittels der Injektionsbarriere jedoch vermieden oder zumindest stark vermindert.

Mögliche Injektionspfade von Ladungsträgern sind in Figur 2 in einem vergrößerten Ausschnitt anhand von Pfeilen schematisch dargestellt. Ladungsträger können vom Kontakt 4 über die Tunnelkontaktschicht 34 in die außerhalb des Halbleiterkörpers angeordnete Stromverbreiterungsschicht 31 gelangen. In dieser Stromverbreiterungsschicht kann sich der Strom in lateraler Richtung aufweiten und nachfolgend über die Tunnelkontaktschicht 34 in den Halbleiterkörper 2 injiziert werden. Mittels der Stromverbreiterungsschicht 31 kann auf diese Weise eine großflächige Injektion von Ladungsträgern auch für den Fall erzielt werden, dass die Tunnelkontaktschicht 34 eine vergleichsweise geringe Querleitfähigkeit aufweist. Die Tunnelkontaktschicht 34 kann also sehr dünn, etwa mit einer Dicke von 100 nm oder weniger, bevorzugt 20 nm oder weniger, besonders bevorzugt 10 nm oder weniger, ausgebildet sein.

Weiterhin ist der Kontakt 4, insbesondere die Kontaktschicht 41, im Unterschied zum im Zusammenhang mit Figur 1 beschriebenen ersten Ausführungsbeispiel von der Stromverbreiterungsschicht 31 in lateraler Richtung beabstandet. Der Kontakt und die Stromverbreiterungsschicht sind also nicht direkt, sondern über die Tunnelkontaktschicht 34 elektrisch leitend miteinander verbunden. Die Injektion von Ladungsträgern in den Halbleiterkörper erfolgt im Unterschied zum ersten Ausführungsbeispiel also in dem Bereich der Grenzfläche 25 des Halbleiterkörpers 2, in dem der Kontakt 4, insbesondere die Kontaktschicht 41, an den Halbleiterkörper angrenzt. Der Kontakt 4 ist hierbei vorzugsweise hinsichtlich eines geringen Kontaktwiderstands zum Halbleiterkörper 2 ausgebildet.

Der in Figur 2 dargestellte Halbleiterchip weist ferner keine Schutzschicht auf. Eine solche Schutzschicht kann aber ebenfalls vorgesehen und insbesondere wie im ersten Ausführungsbeispiel beschrieben ausgeführt sein.

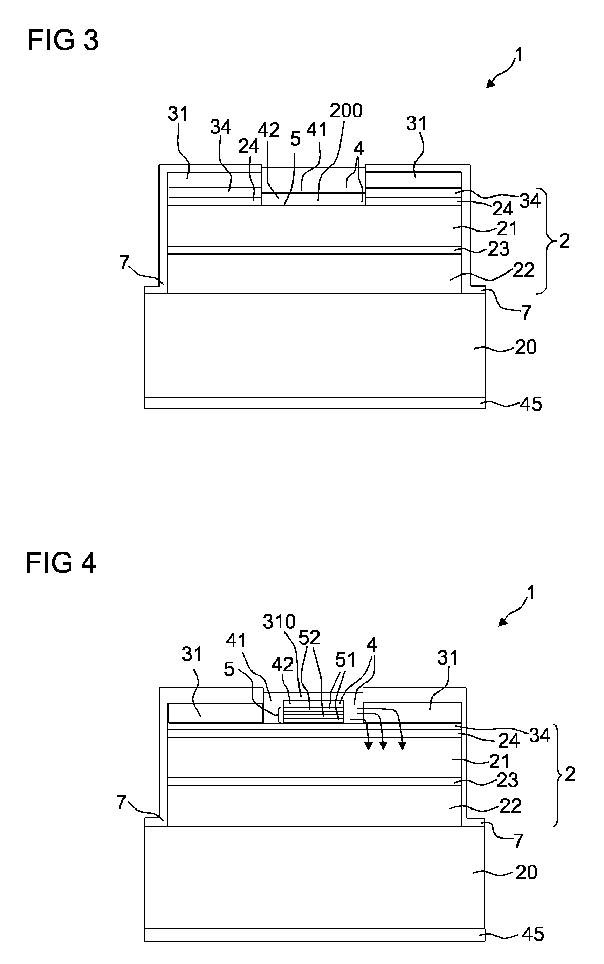

Ein drittes Ausführungsbeispiel für einen erfindungsgemäßen Halbleiterchip ist in Figur 3 in schematischer Schnittansicht dargestellt. Das dritte Ausführungsbeispiel entspricht im Wesentlichen dem in Zusammenhang mit Figur 1 beschriebenen ersten Ausführungsbeispiel. Im Unterschied dazu weist der Halbleiterkörper 2 wie im Zusammenhang mit Figur 2 beschrieben eine Tunnelkontaktschicht 34 und eine weitere Tunnelkontaktschicht 24 auf.

Weiterhin weist der Halbleiterkörper 2 eine Ausnehmung 200 auf. Der Kontakt 4 ist in der Ausnehmung 200 angeordnet. Mittels der Ausnehmung ist die p-leitende Halbleiterschicht 21 freigelegt. Die Tunnelkontaktschicht 34 und die weitere Tunnelkontaktschicht 24 sind in dem Bereich des Kontakts 4 also entfernt. Da die p-leitende Halbleiterschicht 21 eine geringere Dotierkonzentration aufweist als die Tunnelkontaktschichten 24, 34, kann so eine hohe Potenzialbarriere, insbesondere eine Schottky-Barriere, zwischen dem Kontakt 4, insbesondere zwischen der Spiegelschicht 42, und dem Halbleiterkörper, insbesondere der p-leitenden Halbleiterschicht 21, vereinfacht gebildet werden. Eine direkte vertikale Injektion vom Kontakt 4 in den aktiven Bereich 23 kann so verringert werden.

Wie im Zusammenhang mit Figur 2 beschrieben erfüllen die Tunnelkontaktschicht 34 und die weitere Tunnelkontaktschicht 24 insbesondere die Funktion der Anschlussschicht 32 des im Zusammenhang mit Figur 1 beschriebenem ersten Ausführungsbeispiels. Eine Anschlussschicht, die auf dem Halbleiterkörper 2 angeordnet ist und sich zwischen der Stromverbreiterungsschicht 31 und dem Halbleiterkörper befindet, ist entsprechend nicht vorgesehen.

Im Betrieb des Halbleiterchips 1 werden Ladungsträger in die Kontaktschicht 41 injiziert. Von dort gelangen die Ladungsträger in lateraler Richtung in die Stromverbreiterungsschicht 31, welche an die Kontaktschicht in lateraler Richtung unmittelbar angrenzt. Von der Stromverbreiterungsschicht werden die Ladungsträger in vertikaler Richtung in den Halbleiterkörper 2 injiziert und gelangen so in den aktiven Bereich 23, wobei eine Injektion in den aktiven Bereich unterhalb des Kontakts wiederum vermindert ist.

Ein viertes Ausführungsbeispiel für einen erfindungsgemäßen Halbleiterchip ist in Figur 4 in einer schematischen Schnittansicht dargestellt. Dieses vierte Ausführungsbeispiel entspricht im Wesentlichen dem im Zusammenhang mit Figur 1 beschriebenen ersten Ausführungsbeispiel. Im Unterschied zum ersten Ausführungsbeispiel weist der Halbleiterkörper 2 eine Tunnelkontaktschicht 34 und eine weitere Tunnelkontaktschicht 24 auf. Die Tunnelkontaktschicht 34 und die weitere Tunnelkontaktschicht 24 erstrecken sich vollflächig über die p-leitende Halbleiterschicht 21.

Die Injektionsbarriere 5 ist in dem vierten Ausführungsbeispiel mittels einer Mehrzahl von Isolationsschichten 51, 52 gebildet, die auf dem Halbleiterkörper angeordnet ist. Die Injektionsbarriere ist also außerhalb des Halbleiterkörpers 2 angeordnet und befindet sich zumindest bereichsweise zwischen dem Kontakt 4 und dem Halbleiterkörper 2. Mittels der Isolationsschichten kann auf einfache Weise eine Injektion von Ladungsträgern vom Kontakt 4 in einen an die Isolationsschicht angrenzenden Bereich des Halbleiterkörpers vermieden werden.

Die Isolationsschichten 51 und 52 bilden jeweils ein Schichtpaar, wobei die Schichten voneinander verschiedene Brechungsindizes aufweisen. Mittels dieser Schichtpaare ist ein dielektrischer Spiegel in Form eines Bragg-Spiegels gebildet. Im Betrieb des Halbleiterchips 1 im aktiven Bereich 23 erzeugte Strahlung, die in Richtung des Kontakts 4 abgestrahlt wird und auf die dielektrischen Schichten 51, 52 auftrifft, kann so in den Halbleiterkörper mit einer vergleichsweise hohen Reflektivität, bevorzugt von mindestens 80%, besonders bevorzugt mindestens 90%, in den Halbleiterkörper zurück reflektiert werden. Nachfolgend kann diese Strahlung aus dem Halbleiterchip 1 austreten. Die Auskoppeleffizienz des Halbleiterchips kann so gesteigert werden. Je höher die Anzahl der Schichtpaare ist, desto höher kann die Reflektivität des Bragg-Spiegels sein. Die Injektionsbarriere kann also gleichzeitig die Funktion eines hocheffizienten Spiegels erfüllen. Andererseits steigt mit der Zahl der Isolationsschichten auch die Abscheidedauer. Insbesondere im Hinblick auf eine kurze Abscheidedauer kann daher vom gezeigten Ausführungsbeispiel abweichend zwischen dem Halbleiterkörper 2 und dem Kontakt 4 auch nur eine einzelne Isolationsschicht ausgebildet sein.

Der Kontakt 4 weist wiederum eine Kontaktschicht 41 und eine Spiegelschicht 42 auf. Die Spiegelschicht 42 bedeckt die Isolationsschichten 51, 52. Im aktiven Bereich 23 des Halbleiterchips 1 erzeugte und durch den mittels der Isolationsschichten 51, 52 gebildeten Bragg-Spiegels transmittierte Strahlung kann so von der Spiegelschicht 42 in den Halbleiterkörper 2 zurück reflektiert werden. Durch die den Bragg-Spiegel auf der dem Halbleiterkörper abgewandten Seite angeordnete Spiegelschicht kann ein Spiegel mit besonders hoher Gesamtreflektivität ausgebildet werden. Insbesondere können von der Spiegelschicht Strahlungsanteile, die von dem Bragg-Spiegel transmittiert werden, in den Halbleiterkörper zurückreflektiert werden und nachfolgend aus dem Halbleiterchip 1 austreten.

Weiterhin weist die Kontaktschicht 41 im Unterschied zum in Figur 1 gezeigten Ausführungsbeispiel in lateraler Richtung eine größere Ausdehnung auf als die Spiegelschicht 42. Die Kontaktschicht 41 kann also die Spiegelschicht 42, insbesondere vollständig, überformen. In lateraler Richtung verläuft die Kontaktschicht 41 somit zwischen der Stromverbreiterungsschicht 31 und der Injektionsbarriere 5, also den Isolationsschichten 51, 52. Ferner verläuft die Kontaktschicht in lateraler Richtung zwischen der Spiegelschicht 42 und der Stromverbreiterungsschicht 31. Ladungsträger können so vereinfacht von der Kontaktschicht direkt in die Stromverbreiterungsschicht gelangen. Mögliche Strompfade sind in Figur 4 wiederum mittels Pfeilen veranschaulicht.

Die Spiegelschicht 42 kann hierbei unabhängig von den elektrischen Kontakteigenschaften insbesondere im Hinblick auf eine möglichst gute Verspiegelung des mittels der Isolationsschichten 51, 52 gebildeten Bragg-Spiegels auf dessen dem Halbleiterkörper abgewandten Seite ausgebildet werden.

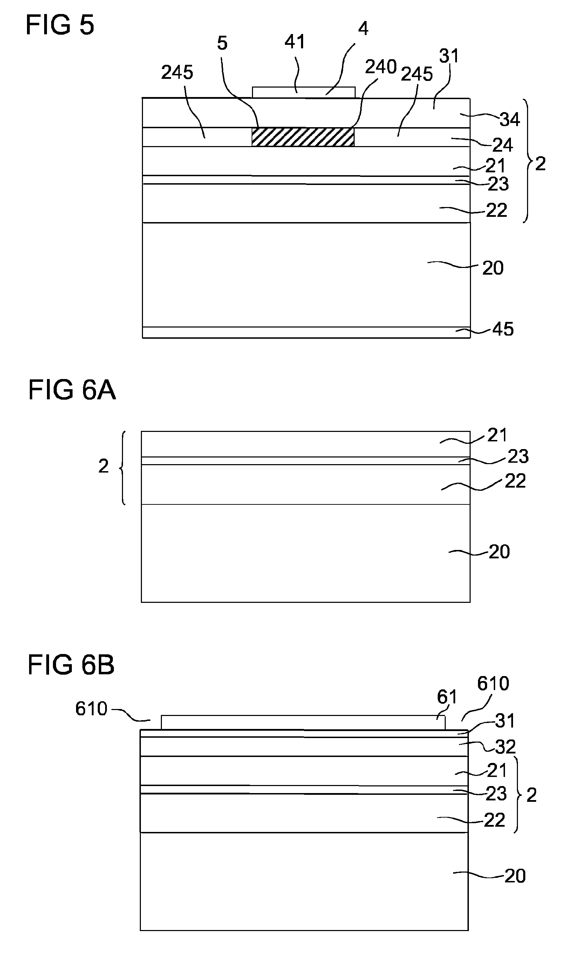

Ein fünftes Ausführungsbeispiel für einen erfindungsgemäßen Halbleiterchip ist in Figur 5 anhand einer schematischen Schnittansicht gezeigt. Im Unterschied zu den vorangegangenen Ausführungsbeispielen ist die Stromverbreiterungsschicht 31 in den Halbleiterkörper 2 integriert. Die Stromverbreiterungsschicht 31 ist hierbei mittels einer Tunnelkontaktschicht 34 gebildet. Auf der dem aktiven Bereich 23 abgewandten Seite der Tunnelkontaktschicht ist der Kontakt 4 angeordnet. Die Injektionsbarriere 5 ist wie im Zusammenhang mit Figur 2 beschrieben mittels eines Bereichs 240 der Tunnelkontaktschicht 24 gebildet. In diesem Bereich ist die elektrische Leitfähigkeit der weiteren Tunnelkontaktschicht 24 geringer als außerhalb dieses Bereichs, also in einem lateral benachbarten Bereich 245. In diesem Ausführungsbeispiel ist die Tunnelkontaktschicht 34 hinreichend dick, um eine ausreichend hohe Querleitfähigkeit aufzuweisen. Eine großflächige Injektion von Ladungsträgern außerhalb der Injektionsbarriere 5 in den aktiven Bereich 23 wird so vereinfacht. Auf eine außerhalb des Halbleiterkörpers angeordnete Stromverbreiterungsschicht kann in diesem Fall verzichtet werden.

In diesem Ausführungsbeispiel weist der Kontakt 4 zum Halbleiterkörper 2 vorzugsweise einen möglichst geringen, insbesondere ohmschen, Kontaktwiderstand auf. Hierfür kann die Kontaktschicht 41 auch mehrschichtig ausgebildet sein. Beispielsweise eignet sich für die Kontaktschicht von dem Halbleiterkörper aus gesehen eine Schichtfolge von Titan, Platin und Gold. Im Betrieb des Halbleiterchips werden Ladungsträger vom Kontakt zunächst in vertikaler Richtung in den Halbleiterkörper 2, insbesondere in die Stromverbreiterungsschicht, injiziert. Eine weiter gehende vertikale Injektion in den aktiven Bereich ist mittels des Bereichs 240 verringerter elektrischer Leitfähigkeit vermindert.

Der Kontakt 4 ist auf der Stromverbreiterungsschicht 31 angeordnet. Die Stromverbreiterungsschicht ist in diesem Ausführungsbeispiel in lateraler Richtung unstrukturiert. Die Herstellung des Halbleiterchips wird so vereinfacht. Davon abweichend kann in der Stromverbreiterungsschicht aber eine Ausnehmung vorgesehen sein, in der der Kontakt angeordnet ist.

Ein erstes Ausführungsbeispiel für ein erfindungsgemäßes Verfahren zur Herstellung eines Halbleiterchips ist in den Figuren 6A bis 6E anhand von schematisch dargestellten Zwischenschritten in Schnittansicht gezeigt. Wie in Figur 6A dargestellt, wird ein Halbleiterkörper 2 mit einer Halbleiterschichtenfolge bereitgestellt. Die Halbleiterschichtenfolge, die den Halbleiterkörper 2 bildet, ist vorzugsweise epitaktisch, etwa mittels MOVPE und MBE, auf einem Träger 20 abgeschieden, der als Aufwachssubstrat dient.

Nachfolgend wird, wie in Figur 6B dargestellt, eine Anschlussschicht 32 und eine Stromverbreiterungsschicht 31 auf dem Halbleiterkörper abgeschieden. Dies erfolgt vorzugsweise jeweils mittels Aufdampfens oder Aufsputterns. Hierbei wird zunächst die Anschlussschicht und dann die Stromverbreiterungsschicht 31 abgeschieden.

Auf der Stromverbreiterungsschicht wird eine Maskierungsschicht 61 ausgebildet, die eine laterale Strukturierung aufweist. In einer Aussparung 610 der Maskierungsschicht 61 liegt die Stromverbreiterungsschicht 31 frei. Die Strukturierung der Maskierungsschicht erfolgt vorzugsweise mittels eines Lithographieprozesses. Hierbei ist die Maskierungsschicht bevorzugt eine photosensitive Schicht, etwa eine photosensitive Lackschicht.

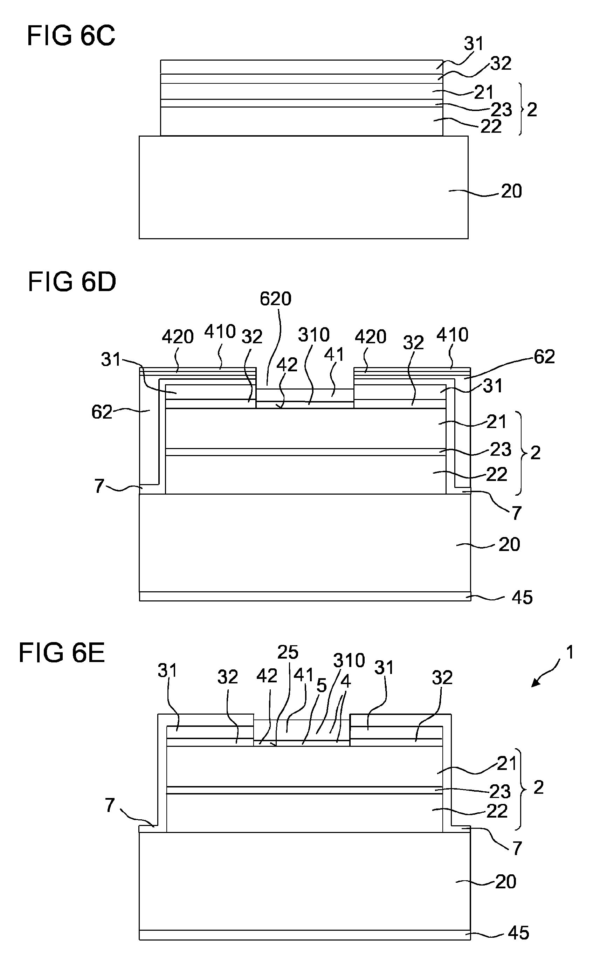

Wie in Figur 6C dargestellt, wird Material der Stromverbreiterungsschicht, der Anschlussschicht 32 und des Halbleiterkörpers 2, das sich unterhalb der Ausnehmung 610 der Maskierungsschicht 61 befindet, entfernt. Die Stromverbreiterungsschicht und der Halbleiterkörper werden also mittels einer gemeinsamen Maskierungsschicht 61 in lateraler Richtung strukturiert. Nach der lateralen Strukturierung der Stromverbreiterungsschicht 31, der Anschlussschicht 32 und des Halbleiterkörpers 2 kann die Maskierungsschicht entfernt werden. Das Übertragen der lateralen Struktur der Maskierungsschicht 61 auf die Stromverbreiterungsschicht 31, die Anschlussschicht 32 und den Halbleiterkörper 2 erfolgt vorzugsweise in einem chemischen Prozess, insbesondere in einem nass-chemischen Ätzprozess oder einem trocken-chemischen Ätzprozess, etwa reaktivem Ionen-Ätzen oder Rücksputtern.

Optional kann nun eine Schutzschicht 7 auf dem Halbleiterkörper, etwa mittels Sputterns oder Aufdampfens, aufgebracht werden.

Auf der Stromverbreiterungsschicht 31, oder gegebenenfalls auf der Schutzschicht 7, wird eine weitere Maskierungsschicht 62 aufgebracht. Diese weitere Maskierungsschicht 62 wird wiederum lateral strukturiert und weist eine Aussparung 620 auf. Die laterale Struktur der weiteren Maskierungsschicht 62 wird nachfolgend auf die Stromverbreiterungsschicht 31 und gegebenenfalls auf die Schutzschicht 7 übertragen. So wird in der Stromverbreiterungsschicht eine Ausnehmung 310 ausgebildet. Dies erfolgt vorzugsweise wiederum in einem nass-chemischen oder trocken-chemischen Ätzschritt.

In einem weiteren Schritt wird, wie in Figur 6D dargestellt, Material für die Spiegelschicht 42 und nachfolgend Material für die Kontaktschicht 41 auf dem Halbleiterkörper 2 abgeschieden. Die Abscheidung der Spiegelschicht 42 und der Kontaktschicht 41 erfolgt vorzugsweise mittels Aufdampfens oder Aufsputterns.

Material 420 für die Spiegelschicht 42, das außerhalb der Aussparung 620 auf der weiteren Maskierungsschicht 62 aufgebracht wurde, wird zusammen mit der weiteren Maskierungsschicht 62 von dem Halbleiterkörper abgehoben. Hierbei wird ebenso Material 410 für die Kontaktschicht 41, das außerhalb der Aussparung 420 auf der Maskierungsschicht 62 aufgebracht wurde, entfernt.

Zur Fertigstellung des Halbleiterchips 1 wird, wie in Figur 6E dargestellt, auf der dem Halbleiterkörper 2 abgewandten Seite des Trägers 20 ein weiterer Kontakt 45 ausgebildet. Der weitere Kontakt 45 enthält vorzugsweise ein Metall, etwa Gold, Silber, Nickel, Titan oder Platin, oder eine metallische Legierung mit zumindest einem dieser Metalle. Die Abscheidung der weiteren Kontaktschicht erfolgt vorzugsweise mittels Aufdampfen oder Aufsputterns.

Bei einem elektrisch nicht leitfähigen Aufwachssubstrat kann dieses beispielsweise bereichsweise entfernt werden, so dass eine Kontaktierung des Halbleiterkörpers mittels des weiteren Kontakts 45 in einem Bereich erfolgen kann, in dem der Halbleiterkörper 2 freigelegt ist.

Alternativ kann das Aufwachssubstrat auch vollständig entfernt oder zumindest gedünnt werden. Der Träger 20 kann dann vom Aufwachssubstrat verschieden sein. Ein Halbleiterchip, bei dem das Aufwachssubstrat entfernt oder gedünnt ist, wird auch als Dünnfilm-Halbleiterchip bezeichnet.

Ein Dünnfilm-Halbleiterchip, etwa ein Dünnfilm-Leuchtdioden-Chip, kann sich weiterhin im Rahmen der vorliegenden Erfindung durch mindestens eines der folgenden charakteristischen Merkmale auszeichnen:
- an einer zu einem Trägerelement, z.B. dem Träger 20, hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug in die vorliegende Anmeldung aufgenommen wird.

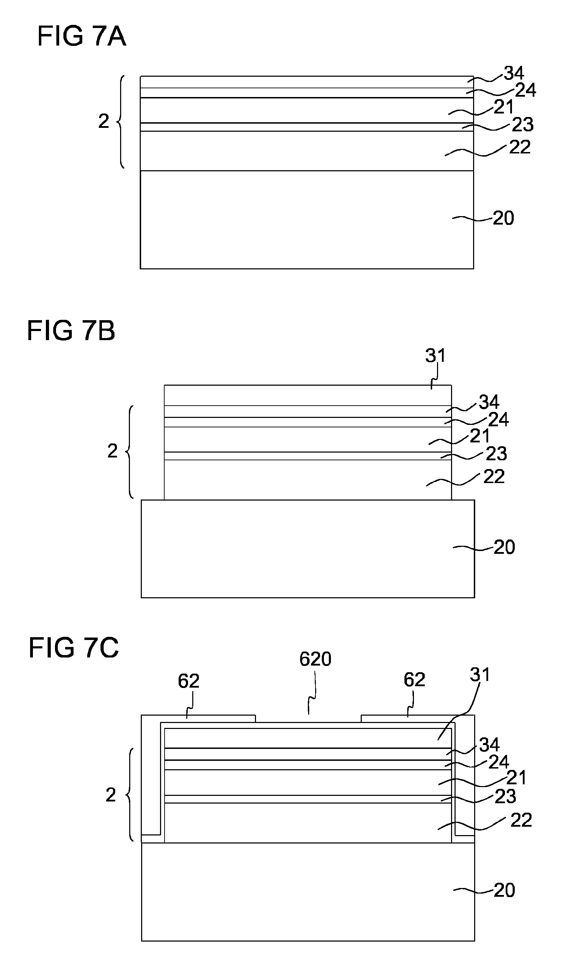

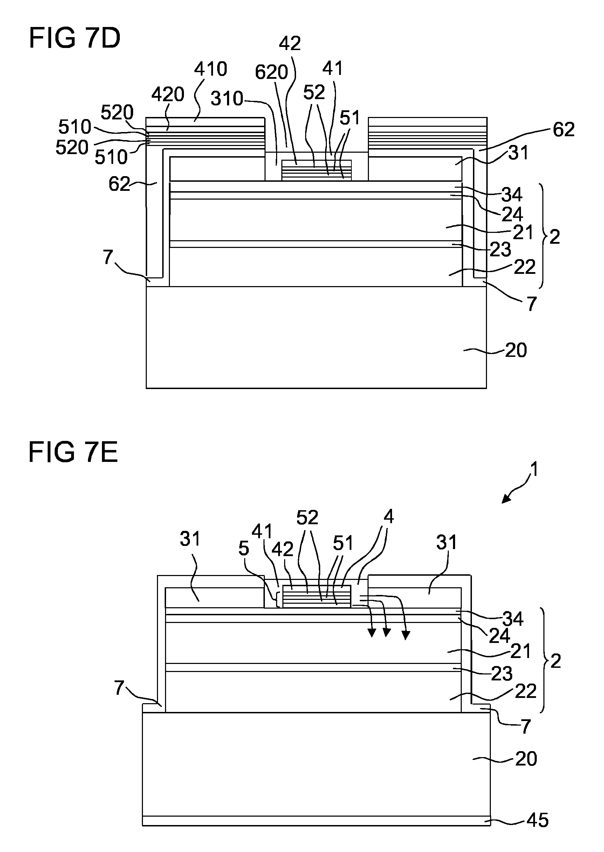

Ein zweites Ausführungsbeispiel für ein erfindungsgemäßes Verfahren ist in den Figuren 7A bis 7E schematisch dargestellt. Wie in Figur 7A gezeigt, wird ein Halbleiterkörper 2 mit einer Halbleiterschichtenfolge bereit gestellt. Die Halbleiterschichtenfolge des Halbleiterkörpers 2 weist wie im Zusammenhang mit Figur 4 beschrieben eine Tunnelkontaktschicht 34 und eine weitere Tunnelkontaktschicht 24 auf.

Auf dem Halbleiterkörper 2 wird eine Stromverbreiterungsschicht 31 aufgebracht. Diese Stromverbreiterungsschicht 31 sowie der Halbleiterkörper 2 werden dann wie im Zusammenhang mit den Figuren 6B und 6C beschrieben lateral strukturiert. Diese laterale Strukturierung kann hierbei wiederum mittels einer Maskierungsschicht, welche in der Figur 7B nicht explizit dargestellt ist, erfolgen.

Daraufhin wird der Halbleiterkörper 2 vollständig mit der Schutzschicht 7 bedeckt (Figur 7C). Die Schutzschicht 7 kann beispielsweise mittels Aufdampfens oder Aufsputterns abgeschieden werden.

Wie im Zusammenhang mit Figur 6B beschrieben, wird eine weitere Maskierungsschicht 62 mit einer Aussparung 620 ausgebildet. Der unterhalb der Ausnehmung 620 frei liegende Bereich der Stromverbreiterungsschicht 31 wird entfernt. Abweichend von Figur 7D kann die Stromverbreiterungsschicht 31 aber auch nur eine Ausnehmung aufweisen, die sich in vertikaler Richtung nicht vollständig durch die Stromverbreiterungsschicht erstreckt.

Auf dem Halbleiterkörper 2 wird nun eine alternierende Abfolge von Isolationsschichten 51 und 52 auf den Halbleiterkörper abgeschieden. Die Abscheidung der Isolationsschichten erfolgt vorzugsweise mittels Aufsputterns oder Aufdampfens. Die Isolationsschicht 51 und die weitere Isolationsschicht 52 ergeben hierbei wie im Zusammenhang mit Figur 4 angegeben ein Schichtpaar mit Schichten unterschiedlicher Brechungsindizes. Durch die Mehrzahl von Schichtenpaaren wird ein dielektrischer Spiegel ausgebildet. In einem darauf folgenden Schritt wird eine Spiegelschicht 42 auf den Isolationsschichten 51, 52 abgeschieden.

Die Abscheidung der Isolationsschichten 51, 52 sowie der Spiegelschicht 42 erfolgt vorzugsweise derart, dass diese Schichten in lateraler Richtung von der
Stromverbreiterungsschicht 31 beabstandet sind. Hierfür kann beispielsweise die Ausnehmung 310 in der
Stromverbreiterungsschicht 31 mittels nasschemischen Ätzens ausgebildet werden. Durch die daraus resultierende Unterätzung kann die Ausnehmung 310 der
Stromverbreiterungsschicht 31 eine größere laterale Ausdehnung aufweisen als die Aussparung 620 der weiteren Maskierungsschicht 62.

Beispielsweise durch Abscheidung der Isolationsschichten 51, 52 und die Spiegelschicht 42 aus senkrechter oder im wesentlichen senkrechter Richtung kann so zwischen diesen Schichten und der Stromverbreiterungsschicht ein Zwischenraum entstehen.

Nachfolgend wird eine Kontaktschicht 41 abgeschieden, welche diesen Zwischenraum, vorzugsweise vollständig, auffüllt. Hierfür erfolgt die Abscheidung der Kontaktschicht 41 vorzugsweise nicht aus senkrechter, sondern schräger Richtung zum Halbleiterkörper bei gleichzeitiger Rotation des Halbleiterkörpers. Auf diese Weise kann die Kontaktschicht 41 die Spiegelschicht 42 und die Isolationsschichten 51, 52 in lateraler Richtung vollständig überformen.

Abweichend von Figur 7D kann das Material für die Kontaktschicht 41 auch in einem separaten Prozess abgeschieden werden, nachdem die weitere Maskierungsschicht 62 zusammen mit dem darauf befindlichen Material bereits entfernt ist. In diesem Fall kann das lateral strukturierte Ausbilden der Kontaktschicht 41 mittels einer dritten Maskierungsschicht erfolgen, die in den Figuren nicht explizit dargestellt ist. Diese dritte Maskierungsschicht wird vorzugsweise vor dem Abscheiden der Kontaktschicht auf dem Halbleiterkörper 2 ausgebildet und lateral strukturiert. Hierbei kann die dritte Maskierungsschicht eine Aussparung aufweisen, die größer ist als die Aussparung 620 der weiteren Maskierungsschicht 62.

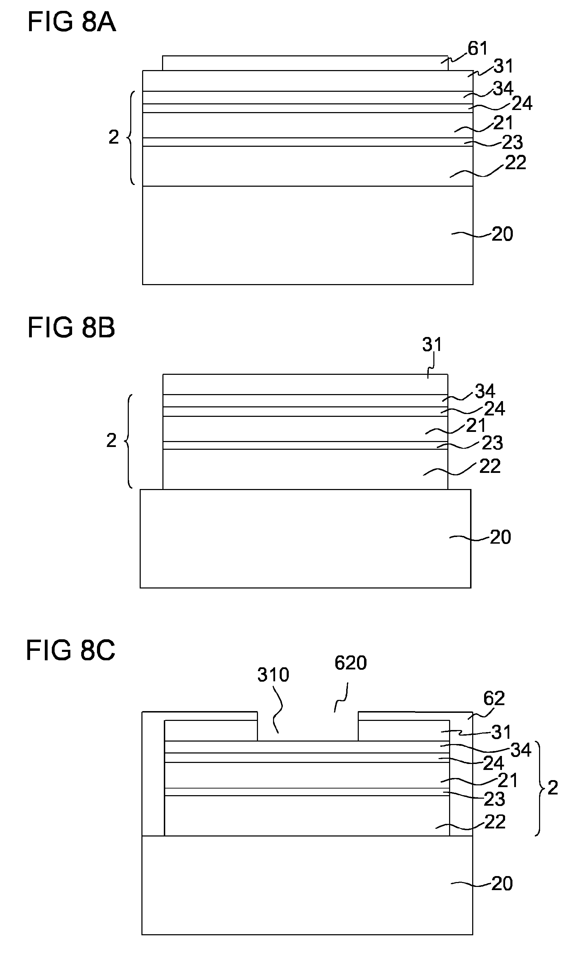

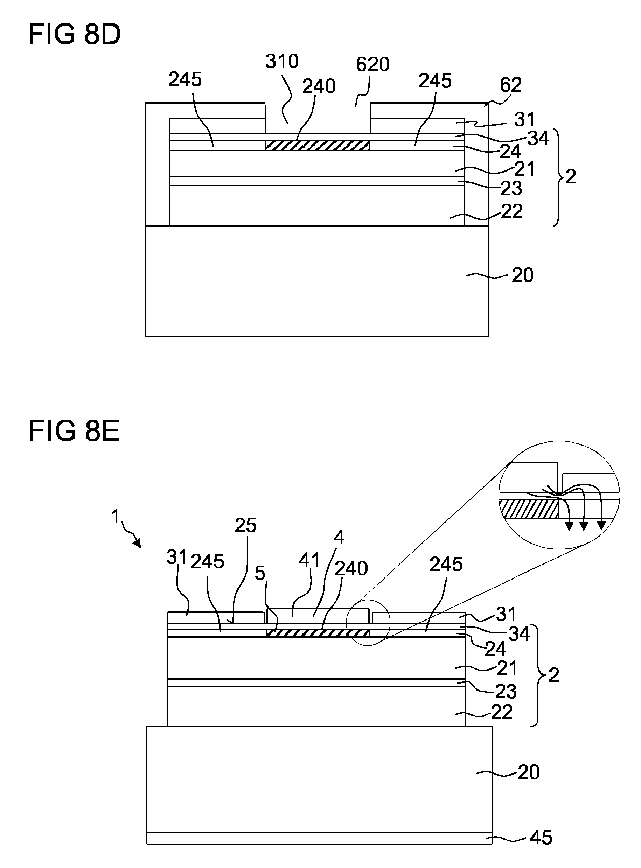

Ein drittes Ausführungsbeispiel für ein erfindungsgemäßes Verfahren ist in den Figuren 8A bis 8E anhand von schematisch dargestellten Zwischenschritten in Schnittansicht gezeigt. Der Halbleiterkörper 2 und die auf dem Halbleiterkörper ausgebildete Stromverbreiterungsschicht 31 sind wie im Zusammenhang mit der Figur 7A beschrieben ausgeführt. Figur 8B entspricht demnach der Figur 7B.

Figur 8A zeigt explizit einen Zwischenschritt, bei dem sich eine in den Figuren 7A und 7B nicht dargestellte Maskierungsschicht 61 auf der Stromverbreiterungsschicht 31 befindet. Wie im Zusammenhang mit Figur 6D beschrieben, wird auf der Stromverbreiterungsschicht 31 eine weitere Maskierungsschicht 62 mit einer Aussparung 620 ausgebildet. Nachfolgend wird die laterale Struktur der Maskierungsschicht 62 in die Stromverbreiterungsschicht 31 übertragen, so dass unterhalb der Aussparung 620 der weiteren Maskierungsschicht 62 eine Ausnehmung 310 in der Stromverbreiterungsschicht 31 ausgebildet wird.

Die Injektionsbarriere 5 wird dadurch ausgebildet, dass in einem Bereich 240 der weiteren Tunnelkontaktschicht 24 die elektrische Leitfähigkeit dieser Schicht lokal verringert wird.

Hierfür eignet sich beispielsweise ein Plasmaverfahren, durch das Akzeptoren, etwa Mg, oder Donatoren, etwa Si, elektrisch deaktiviert werden können. Beispielsweise kann mittels eines Wasserstoff-Plasmas Wasserstoff durch die Aussparung 620 der weiteren Maskierungsschicht 62 hindurch in die weitere Tunnelkontaktschicht 24 eingebracht werden. Dadurch können Akzeptoren in der weiteren Tunnelkontaktschicht, etwa Mg-Akzeptoren in einer InₓAl_{y}Ga_{1-x-y}N-Halbleiterschicht mit 0 ≤ x ≤ 1 und 0 ≤ y ≤ 1, elektrisch deaktiviert werden. Ein Plasmaverfahren ist insbesondere geeignet, wenn der Bereich, in dem die elektrische Leitfähigkeit verringert werden soll, einen geringen Abstand, bevorzugt 100 nm oder weniger, besonders bevorzugt 10 nm oder weniger, zu der Grenzfläche 25 des Halbleiterkörpers 2 aufweist.

Insbesondere bei größeren Abständen des Bereichs 240 von der Grenzfläche 25 des Halbleiterkörpers 2 kann die Leitfähigkeit auch mittels Implantation von Ionen durch die Aussparung 620 der weiteren Maskierungsschicht 62 hindurch lokal verringert werden. Alternativ kann die Kristallstruktur lokal gezielt gestört werden. Hierfür ist beispielsweise Rücksputtern, etwa durch einen Ar-Ionen-Strahl, geeignet. Insbesondere beim Rücksputtern kann hierbei auch Material des Halbleiterkörpers 2 entfernt werden.

Ein fertig gestellter Halbleiterchip 1, der wie im Zusammenhang mit Figur 2 beschrieben ausgeführt ist, ist in Figur 8E dargestellt. Dieser Halbleiterchip weist einen weiteren Kontakt 45 auf, der wie im Zusammenhang mit Figur 6E beschrieben ausgebildet werden kann.

Diese Patentanmeldung beansprucht die Priorität der deutschen Patentanmeldung 10 2007 032 555.1, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.

## Patentansprüche

1. Halbleiterchip (1), umfassend einen Halbleiterkörper (2) mit einer Halbleiterschichtenfolge, die einen zur Erzeugung von Strahlung vorgesehenen aktiven Bereich (23) aufweist, wobei
- auf dem Halbleiterkörper (2) ein Kontakt (4) angeordnet ist und zwischen dem Kontakt (4) und dem aktiven Bereich (23) eine Injektionsbarriere (5) ausgebildet ist;
- der Halbleiterchip eine Stromverteilungsschicht (31) aufweist, die außerhalb des Halbleiterkörpers angeordnet, mit dem Kontakt (4) elektrisch leitend verbunden und im Betrieb des Halbleiterchips (1) in lateraler Richtung außerhalb der Injektionsbarriere (5) zur Injektion von Ladungsträgern in den aktiven Bereich (23) vorgesehen ist;
- die Stromverteilungsschicht (31) eine Ausnehmung (310) aufweist, in der der Kontakt (4) angeordnet ist; und
- die Stromverteilungsschicht (31) und der Kontakt (4) lateral voneinander beabstandet sind.

2. Halbleiterchip nach Anspruch 1,
bei dem die Injektionsbarriere (5) im Halbleiterkörper (29) ausgebildet ist, wobei die Injektionsbarriere (5) mittels eines Bereichs (240) gebildet ist, in dem eine elektrische Leitfähigkeit einer zwischen dem aktiven Bereich (23) und dem Kontakt (4) angeordneten Halbleiterschicht (24) lokal verringert ist.

3. Halbleiterchip nach Anspruch 1 oder 2,
bei dem der Kontakt in vertikaler Richtung von der Injektionsbarriere beabstandet ist.

4. Halbleiterchip nach einem der vorhergehenden Ansprüche,
bei dem der Kontakt in lateraler Richtung deckungsgleich oder im Wesentlichen deckungsgleich mit der Injektionsbarriere verläuft.

5. Halbleiterchip nach einem der vorhergehenden Ansprüche,
bei dem die Injektionsbarriere (5) mittels eines Bereichs gebildet ist, in dem eine elektrische Leitfähigkeit einer zwischen dem Kontakt und dem aktiven Bereich angeordneten lokal verringert ist.

6. Halbleiterchip nach Anspruch 5,
bei dem der Bereich in lateraler Richtung inselartig ausgebildet ist und in seiner lateralen Formgebung an die laterale Formgebung des Kontakts angepasst ist.

7. Halbleiterchip nach Anspruch 5 oder 6,
bei dem Ladungsträger im Betrieb des Halbleiterchips direkt in vertikaler Richtung vom Kontakt in den Halbleiterkörper injiziert werden und eine weitergehende direkte vertikale Injektion in den aktiven Bereich aufgrund dieses Bereichs geringer elektrischer Leitfähigkeit verhindert oder zumindest zugunsten einer gesteigerten Injektion außerhalb dieses Bereichs vermindert wird.

8. Halbleiterchip nach einem der vorhergehenden Ansprüche,
bei dem die Stromverteilungsschicht mittels eines Materials gebildet ist, das für die im aktiven Bereich erzeugte Strahlung durchlässig ist.

9. Halbleiterchip nach einem der vorherigen Ansprüche,
bei dem die Stromverteilungsschicht (31) ein TCO-Material enthält.

10. Halbleiterchip nach Anspruch 9,
bei dem zwischen der Stromverteilungsschicht (31) und dem Halbleiterkörper (2) eine Anschlussschicht (32) angeordnet ist, die ein Metall oder eine metallische Legierung enthält.

11. Halbleiterchip nach einem der vorherigen Ansprüche,
bei dem
- zwischen der Stromverteilungsschicht (31) und dem aktiven Bereich (23) eine Tunnelkontaktschicht (34) angeordnet ist, wobei die Tunnelkontaktschicht (34) bezüglich ihres Leitungstyps von einer weiteren Halbleiterschicht (21), die zwischen der Tunnelkontaktschicht (34) und dem aktiven Bereich (23) angeordnet ist, verschieden ist.

12. Halbleiterchip nach Anspruch 11,
bei dem auf der dem aktiven Bereich (23) zugewandten Seite der Tunnelkontaktschicht (34) eine weitere Tunnelkontaktschicht (24) angeordnet ist, wobei die weitere Tunnelkontaktschicht (24) einen anderen Leitungstyp aufweist als die Tunnelkontaktschicht (34), und bei dem die Injektionsbarriere (5) mittels eines Bereichs (240) der weiteren Tunnelkontaktschicht (24) ausgebildet ist, in dem die elektrische Leitfähigkeit lokal verringert ist.

13. Verfahren zur Herstellung eines Halbleiterchips (1), umfassend einen Halbleiterkörper (2) mit einer Halbleiterschichtenfolge, die einen zur Erzeugung von Strahlung vorgesehenen aktiven Bereich (23) aufweist, bei dem auf dem Halbleiterkörper (2) ein Kontakt (4) aufgebracht wird, wobei zwischen dem aktiven Bereich (23) und dem Kontakt (4) eine Injektionsbarriere (5) gebildet ist und wobei eine Stromverteilungsschicht (31) außerhalb des Halbleiterkörpers gebildet ist, wobei die Stromverteilungsschicht eine Ausnehmung (310) aufweist, in der der Kontakt (4) angeordnet ist, wobei die Stromverteilungsschicht (31) und der Kontakt (4) lateral voneinander beabstandet sind.

14. Verfahren nach Anspruch 13,
bei dem die Injektionsbarriere (5) mittels eines Bereichs (240) einer Halbleiterschicht (24) gebildet wird, in dem eine elektrische Leitfähigkeit der Halbleiterschicht (24) mittels Ionen-Implantation lokal verringert wird.

15. Verfahren nach Anspruch 13,
bei dem die Injektionsbarriere (5) mittels eines Bereichs (240) einer Halbleiterschicht (24) gebildet wird, in dem eine elektrische Leitfähigkeit der Halbleiterschicht (24) mittels eines Plasmaverfahrens und/oder mittels Rücksputterns lokal verringert wird.
